(19) Europäisches Patentamt / European Patent Office / Office européen des brevets

(11) **EP 2 975 815 B1**

(12) **FASCICULE DE BREVET EUROPEEN**

(45) Date de publication et mention de la délivrance du brevet:
**17.05.2017 Bulletin 2017/20**

(51) Int Cl.:
*H04L 27/26* [(2006.01)]    *H04B 1/66* [(2006.01)]
*H04B 1/04* [(2006.01)]

(21) Numéro de dépôt: **15176543.5**

(22) Date de dépôt: **13.07.2015**

(54) **PROCEDE DE REDUCTION DU FACTEUR DE CRETE D'UN SIGNAL LARGE-BANDE**

VERFAHREN ZUR REDUZIERUNG DES SCHEITELFAKTORS EINES BREITBANDSIGNALS

METHOD FOR REDUCING THE PEAK FACTOR OF A BROADBAND SIGNAL

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **15.07.2014 FR 1401582**

(43) Date de publication de la demande:
**20.01.2016 Bulletin 2016/03**

(73) Titulaire: **AIRBUS DS SAS**
**78990 Elancourt (FR)**

(72) Inventeurs:
• **MEGE, Philippe**
  **92340 Bourg la Reine (FR)**
• **MOLKO, Christophe**
  **78450 Villepreux (FR)**

(74) Mandataire: **Cabinet Camus Lebkiri**
**25 rue de Maubeuge**
**75009 Paris (FR)**

(56) Documents cités:
**EP-A1- 1 515 504**      **WO-A1-96/13918**
**WO-A1-2010/139095**   **US-A- 5 201 071**
**US-B1- 6 445 747**

• **GIMLIN D R ET AL: "ON MINIMIZING THE PEAK-TO-AVERAGE POWER RATIO FOR THE SUM OF N SINUSOIDS", IEEE TRANSACTIONS ON COMMUNICATIONS, IEEE SERVICE CENTER, PISCATAWAY, NJ. USA, vol. 41, no. 4, 1 avril 1993 (1993-04-01), pages 631-635, XP000615794, ISSN: 0090-6778, DOI: 10.1109/26.223788**
• **TAO JIANG ET AL: "On minimizing the peak-to-average power ratio of multi-carrier modulation signals using simulated annealing", ELECTRO/INFORMATION TECHNOLOGY, 2007 IEEE INTERNATIONAL CONFERENCE ON, IEEE, PI, 1 mai 2007 (2007-05-01), pages 43-46, XP031156016, ISBN: 978-1-4244-0940-2**
• **AGGARWAL A ET AL: "Minimizing the peak-to-average power ratio of OFDM signals via convex optimization", GLOBECOM'03. 2003 - IEEE GLOBAL TELECOMMUNICATIONS CONFERENCE. CONFERENCE PROCEEDINGS. SAN FRANCISCO, CA, DEC. 1 - 5, 2003; [IEEE GLOBAL TELECOMMUNICATIONS CONFERENCE], NEW YORK, NY : IEEE, US, vol. 4, 1 décembre 2003 (2003-12-01), pages 2385-2389, XP010677782, DOI: 10.1109/GLOCOM.2003.1258662 ISBN: 978-0-7803-7974-9**

**Description**

## DOMAINE TECHNIQUE

La présente invention se rapporte aux systèmes d'amplification et d'émission de signaux large-bande comprenant plusieurs signaux bande-étroite. L'invention concerne plus particulièrement la réduction du facteur de crête d'un signal large-bande ainsi qu'un équipement émetteur et un programme d'ordinateur correspondants.

## ETAT DE L'ART

Les transmissions dites « multi-porteuses », par exemple de type OFDM, sont de plus en plus fréquemment utilisées et ont notamment été adoptées dans les systèmes LTE (« Long Term Evolution »), TEDS (« TETRA Enhanced Data Service »), DAB (« Digital Audio Broadcasting ») et DVB-T (« Digital Video Broadcasting-Terrestrial »).

Dans les systèmes de transmission à multi-porteuses, les données sont généralement codées sous forme de symboles envoyés par un équipement émetteur, appelé dans la suite « émetteur », dans des signaux émis sur une pluralité de sous-porteuses à différentes fréquences à destination d'un équipement récepteur, appelé dans la suite « récepteur ».

Afin de permettre à ces signaux d'atteindre aisément le récepteur, l'émetteur comprend de manière connue un amplificateur qui augmente la puissance des signaux avant leur émission. Un tel amplificateur de puissance transforme le signal d'entrée en un signal de sortie de puissance plus élevée.

Un amplificateur de puissance de signaux large-bande est en général linéarisé de façon à ce que, pour un signal d'entrée dont la puissance est située en dessous d'une certaine limite le signal de sortie soit proportionnel ou quasi-proportionnel au signal d'entrée (on dit que le signal est dans l'intervalle dit "de linéarité" de l'amplificateur de puissance).

Lorsque la valeur d'amplitude du signal d'entrée dépasse la limite maximale supérieure de l'intervalle de linéarité, l'amplificateur de puissance fonctionne dans un intervalle d'amplitude du signal d'entrée dit « de non-linéarité » pour lequel le signal de sortie de l'amplificateur se trouve limité. Le spectre de fréquences du signal se trouve alors élargi et les composants de l'amplificateur de puissance peuvent se dégrader indument, ce qui présente des inconvénients.

Dans un système de transmission à multi-porteuses, l'utilisation d'une pluralité de sous-porteuses pour transmettre les données peut créer des pics d'amplitude, dépendant notamment du nombre de sous-porteuses. Ces pics d'amplitude peuvent atteindre des valeurs qui peuvent dépasser la limite maximale supérieure de l'intervalle de linéarité de l'amplificateur de puissance, entrainant alors les inconvénients précités.

Afin de résoudre au moins en partie ces inconvénients, il est connu de dimensionner l'amplificateur par rapport aux pics du signal de sorte que l'amplification du signal soit linéaire sur toute la gamme de variation dudit signal.

En pratique, dans ce but, on cherche à réduire le facteur de crête (Peak-to-Average Power Ratio ou PAPR en langue anglaise) du signal, c'est à dire le rapport entre l'amplitude de pic du signal et sa valeur efficace, de manière à ce qu'il se trouve dans la région de linéarité de l'amplificateur. En effet, la réduction du facteur de crête permet une augmentation de la valeur efficace du signal, qui est la valeur "utile" caractérisant la puissance transmise, et qui est donc la valeur à maximiser. Le facteur de crête représente la marge entre la puissance maximale de l'amplificateur (la puissance pour laquelle il est dimensionné), et la puissance réellement transmise, c'est pourquoi il est important de minimiser le facteur de crête afin de dimensionner l'amplificateur de puissance au plus juste par rapport à la puissance à transmettre, ce qui permet notamment de réduire le volume et la masse de l'amplificateur et de limiter sa consommation énergétique.

Les méthodes connues pour réduire le facteur de crête ont toutes l'inconvénient majeur d'entrainer une dégradation du signal.

De plus, dans le cas d'une pluralité de signaux bande-étroite envoyés dans un signal large-bande, par exemple des signaux de type TETRA ou TETRAPOL envoyés dans un signal large-bande, la présence de séquences de symboles (appelées « training sequences ») communes entre les signaux et synchrones entre elles augmente leur cohérence et donc impacte la distribution statistique des amplitudes en augmentant la probabilité d'occurrence des amplitudes les plus grandes, ce qui nécessite, avec les solutions existantes, une réduction d'amplitude du signal qui dégradera les signaux utiles et qui est donc problématique.

## PRESENTATION GENERALE DE L'INVENTION

La présente invention vise à remédier au moins en partie à ces inconvénients en proposant un procédé efficace et aisé à mettre en oeuvre de réduction du facteur de crête d'un signal large-bande permettant de réduire le facteur de crête et d'optimiser la distribution statistique des amplitudes dudit signal large-bande afin de limiter fortement voire de supprimer la dégradation de signaux bande-étroite compris dans le signal large-bande.

A cet effet, l'invention concerne tout d'abord un procédé de réduction du facteur de crête d'un signal large-bande comprenant N signaux bande-étroite, N étant un nombre entier naturel supérieur ou égale à deux, le procédé, mis en oeuvre par un équipement émetteur, étant remarquable en ce qu'il comprend une étape de déphasage des signaux bande-étroite entre eux de manière à réduire ledit facteur de crête.

Par les termes « signal large-bande », on entend un signal occupant une bande de fréquence plus large que la somme des largeurs de bandes des différents "signaux bande-étroite" qui sont transmis dans ce dit "signal large-bande". La largeur d'un signal large-bande, par exemple dans un réseau de type 3GPP LTE bien connu de l'homme du métier, est typiquement comprise entre 1 et 20 MHz.

Par les termes « signal bande-étroite », on entend un signal occupant une faible bande de fréquences, par exemple des signaux de type TETRA bien connu de l'homme du métier, dont la largeur est typiquement inférieure à 200 kHz (entre 25 et 150 kHz dans un réseau TETRA).

Par les termes « signal large-bande comprenant une pluralité de signaux bande-étroite », on entend que la pluralité des signaux bande-étroite sont transmis dans la bande du signal large-bande.

Le déphasage des signaux bande-étroite permet avantageusement de réduire significativement le facteur de crête du signal large-bande.

En outre, lorsque les signaux bande-étroite sont au moins en partie cohérents entre eux, le procédé selon l'invention permet d'optimiser la distribution statistique des amplitudes du signal large-bande. Par le terme « cohérents », on entend la présence de séquences de symboles communes entre les signaux et synchrones entre elles. De telles séquences sont communément appelées « training sequences » par l'homme du métier.

De préférence, les valeurs de déphasage des signaux bande-étroite sont déterminées dans une étape préliminaire.

De préférence encore, les valeurs de déphasage des signaux bande-étroite sont déterminées de manière périodique afin de réduire le facteur de crête et, lorsque les signaux bande-étroite sont au moins en partie cohérents entre eux, d'optimiser la distribution statistique des amplitudes du signal large-bande dans le temps.

Avantageusement, le procédé comprend une étape préliminaire d'initialisation des valeurs de déphasage des signaux bande-étroite, par exemple en les choisissant de manière aléatoire.

Dans un mode de mise en oeuvre préféré du procédé selon l'invention, les valeurs de déphasage des signaux bande-étroite sont déterminées à partir des signaux émis à un instant antérieur par l'équipement émetteur. Cela permet d'optimiser la réduction du facteur de crête du signal large-bande et, lorsque les signaux bande-étroite sont au moins en partie cohérents entre eux, la distribution statistique des amplitudes du signal large-bande.

Selon un aspect de l'invention, l'équipement émetteur comprenant un amplificateur de puissance et/ou un simulateur d'amplification de puissance, les valeurs de déphasages des signaux bande-étroite sont déterminées à partir de l'erreur (ou différence) entre la valeur du signal amplifié par ledit amplificateur de puissance ou ledit simulateur d'amplification de puissance et la valeur du signal généré par le module de génération.

Avantageusement, l'équipement émetteur comprenant un amplificateur de puissance et/ou un simulateur d'amplification de puissance, les valeurs de déphasages des signaux bande-étroite sont déterminées en minimisant l'erreur quadratique entre la valeur du signal amplifié par ledit amplificateur de puissance ou ledit simulateur d'amplification de puissance et la valeur du signal généré par le module de génération afin de réduire de manière optimale le facteur de crête et, lorsque les signaux bande-étroite sont au moins en partie cohérents entre eux, d'optimiser la distribution statistique des amplitudes du signal large-bande.

De préférence, les valeurs de déphasage des signaux bande-étroite sont déterminées en utilisant un gradient stochastique qui minimise ladite erreur quadratique, ce qui permet d'obtenir dans le temps un facteur de crête minimal, et, lorsque les signaux bande-étroite sont au moins en partie cohérents entre eux, une distribution statistique des amplitudes du signal large-bande optimale.

De préférence, le pas de l'algorithme du gradient stochastique, utilisé pour déterminer les valeurs de déphasages des signaux bande-étroite, est plus rapide sur les portions de temps où les signaux bande-étroite, exprimés en bande de base, sont au moins en partie cohérents entre eux, et moins rapide sur les autres portions de temps.

De manière avantageuse, l'algorithme du gradient stochastique, utilisé pour déterminer les valeurs de déphasages des signaux bande-étroite, est appliqué uniquement sur les portions de temps où les signaux bande-étroite, exprimés en bande de base, sont cohérents entre eux.

Dans une autre forme de mise en oeuvre, les valeurs de déphasage des signaux bande-étroite sont déterminées de manière aléatoire, de préférence périodiquement, ce qui est aisé à réaliser.

Dans une autre forme de mise en oeuvre, le déphasage des signaux bande-étroite est réalisé en décalant temporellement les signaux bande-étroite les uns par rapport aux autres.

L'invention concerne également un équipement émetteur comprenant un module de génération d'un signal large-bande à partir de N signaux bande-étroite, N étant un nombre entier naturel supérieur ou égale à deux, et un amplificateur de puissance dudit signal large-bande, ledit équipement émetteur étant remarquable en ce que le module de génération est configuré pour déphaser les signaux bande-étroite entre eux de manière à réduire le facteur de crête du signal large-bande et, lorsque les signaux bande-étroite sont au moins en partie cohérents entre eux, à optimiser la distribution statistique des amplitudes du signal large-bande.

Dans une forme de réalisation, l'équipement émetteur comprend un simulateur d'amplification de puissance configuré pour simuler l'amplification d'un signal large-bande généré par le module de génération.

L'invention concerne aussi un programme d'ordinateur comportant des instructions pour la mise en oeuvre du procédé de l'invention lorsque le programme est exécuté par au moins un processeur.

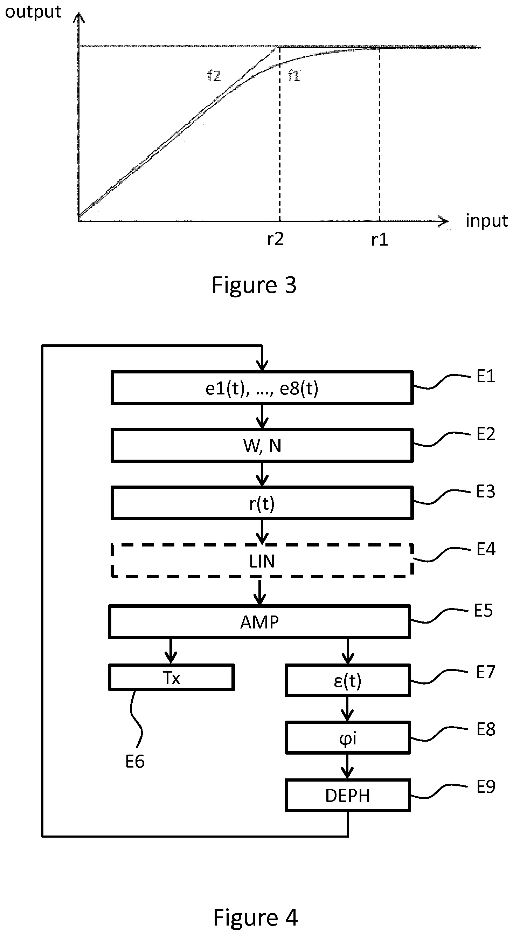

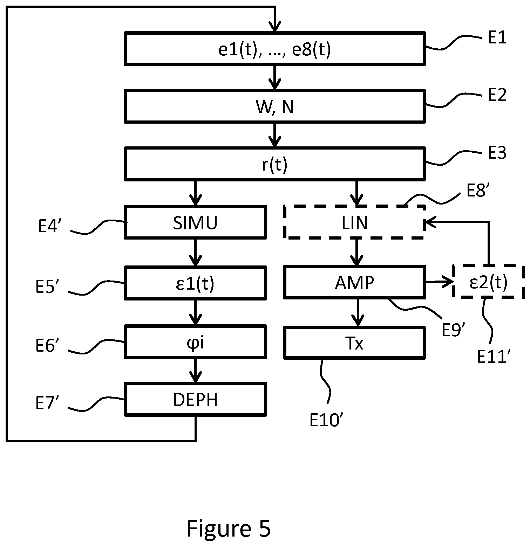

Les organigrammes des figures 4 et 5 illustrent schématiquement le déroulement de ce programme d'ordinateur, pour des modes de mise en oeuvre préférés de l'invention.

## DESCRIPTION DES FIGURES

Des modes de réalisation de l'invention vont maintenant être décrits de façon plus précise mais non limitative en regard des dessins annexés sur lesquels :

- la figure 1 illustre schématiquement une première forme de réalisation d'un équipement émetteur selon l'invention ;
- la figure 2 illustre schématiquement une deuxième forme de réalisation d'un équipement émetteur selon l'invention ;
- la figure 3 illustre deux exemples de courbes représentant deux fonctions de simulation d'amplification ;
- la figure 4 illustre schématiquement un premier mode de mise en oeuvre du procédé selon l'invention par l'équipement émetteur de la figure 1 ;
- la figure 5 illustre schématiquement un deuxième mode de mise en oeuvre du procédé selon l'invention par l'équipement émetteur de la figure 2;
- la figure 6 illustre un premier exemple d'application du deuxième mode de mise en oeuvre du procédé selon l'invention ;
- la figure 7 illustre un deuxième exemple d'application du deuxième mode de mise en oeuvre du procédé selon l'invention.

## DESCRIPTION DETAILLEE DE L'INVENTION

### I. Equipement émetteur 2A/2B

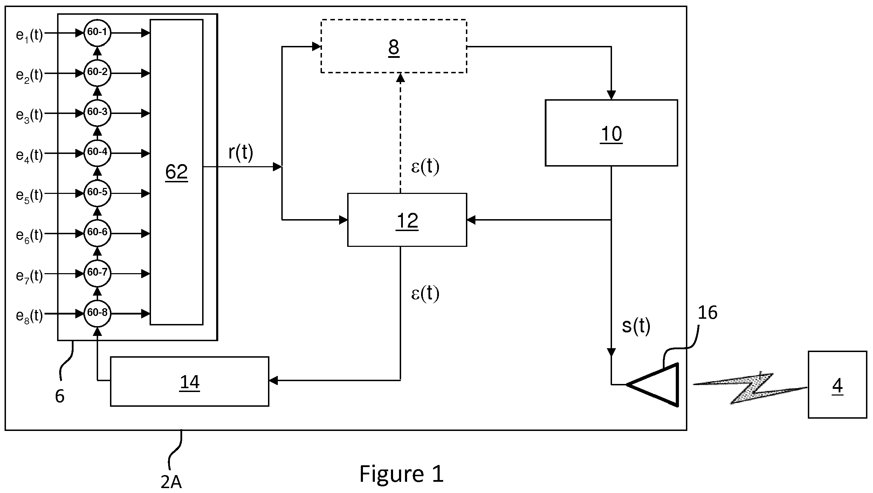

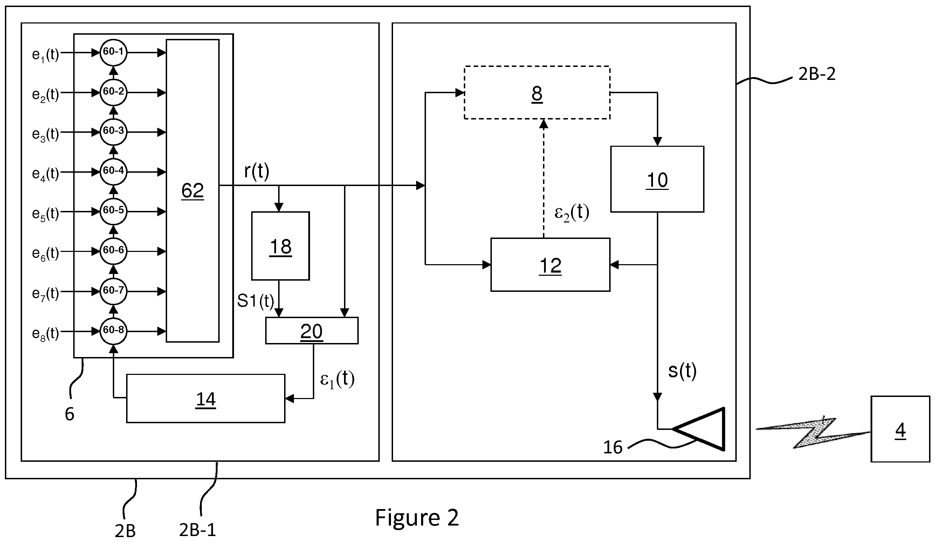

Les figures 1 et 2 représentent un équipement émetteur 2A/2B d'un système de transmission d'une pluralité de signaux bande-étroite dans un même signal large-bande, comme par exemple une station de base d'un système PMR (« Professional Mobile Radio ») de type TETRAPOL avec plusieurs signaux TETRAPOL transmis dans un même signal large-bande.

L'émetteur 2A/2B est configuré pour émettre un signal large-bande à destination d'un récepteur 4.

A cette fin, l'émetteur 2A/2B comprend un module de génération 6 d'un signal large-bande à partir des signaux bande-étroite, un module de linéarisation 8, un amplificateur de puissance 10, un module de calcul d'erreur 12, un module de détermination des déphasages 14 et un module d'émission 16.

Le signal large-bande émis par l'émetteur 2A/2B comprend un nombre N de signaux bande-étroite $e_1(t)$, ..., $e_N(t)$ où N est un entier naturel supérieur ou égal à 2. L'invention permet de déphaser ces signaux $e_1(t)$, ..., $e_N(t)$ à partir de valeurs de déphasages $\varphi_1$,.., $\varphi_N$.

Pour des raisons de clarté, l'invention va être décrite en référence à un signal large-bande comprenant N = 8 signaux bande-étroite $e_1(t)$, ..., $e_8(t)$. Ceci n'est évidemment pas limitatif de la portée de la présente invention, le nombre de signaux bande-étroite pouvant être tout nombre entier naturel supérieur ou égal à deux.

### a) Module de génération 6 d'un signal large-bande

Le module de génération 6 est configuré pour :

- recevoir huit signaux bande-étroite $e_1(t)$, ..., $e_8(t)$, chacun des huit signaux bande-étroite comprenant une pluralité de symboles,
- déphaser chacun des huit signaux bande-étroite $e_1(t)$, ..., $e_8(t)$ reçus à partir de valeurs de déphasages reçues,
- générer un signal large-bande à partir de huit signaux bande-étroite $e_1(t)$, ..., $e_8(t)$ déphasés entre eux.

Le module de génération 6 comprend huit unités de configuration de phase 60-1, ... 60-8 et une unité de génération 62 d'un signal large-bande.

Les huit unités de configuration de phase 60-1, ... 60-8 sont chacune configurées pour recevoir un et un seul des huit signaux bande-étroite $e_1(t)$, ..., $e_8(t)$ et pour modifier sa phase à partir d'une valeur de déphasage $\varphi_1$,.., $\varphi_8$

fournie par le module de détermination de phase 14 décrit ci-après de sorte que les signaux bande-étroite $e_1(t)$, ..., $e_8(t)$ soient déphasés entre eux.

L'unité de génération 62 est configurée pour générer un signal large-bande à partir des huit signaux bande-étroite $e_1(t)$, ..., $e_8(t)$ déphasés par les unités de configuration de phase 60-1, ... 60-8.

Par exemple, les signaux bande-étroite $e_1(t)$, ..., $e_8(t)$ peuvent être reçus chacun en bande de base, sous forme de signaux complexes. Pour déphaser ces signaux, respectivement avec les valeurs de déphasages $\varphi_1$, .., $\varphi_8$, il suffit de multiplier chacun de ces signaux, respectivement par $e^{j \cdot \varphi_i}$, où j représente le nombre complexe imaginaire pur racine carrée de -1. Puis chacun de ces signaux bande-étroite $e_1(t)$, ..., $e_8(t)$ est placé sur sa fréquence porteuse, le signal large-bande obtenu r(t) comprend alors l'ensemble des signaux large-bande chacun sur sa fréquence porteuse et avec le déphasage désiré.

b) Module de linéarisation 8

Le module de linéarisation 8, qui est optionnel, est une fonction qui est associée en général aux amplificateurs de puissance et qui a pour rôle de pré-distordre les signaux à envoyer à l'amplificateur de puissance 10 de sorte que la réponse globale de l'amplificateur de puissance associé à ce module de linéarisation soit la plus linéaire possible et dans le plus grand intervalle de linéarité. En général, ce module de linéarisation 8 adapte la pré-distorsion qu'il applique aux signaux à envoyer à l'amplificateur de puissance 10 en fonction de l'erreur issue du module de calcul d'erreur 12.

c) Amplificateur de puissance 10

L'amplificateur de puissance 10 est configuré pour augmenter la puissance d'un signal large-bande r(t) généré par le module de génération 6 (et pré-distordu par le module de linéarisation 8 le cas échéant).

Un tel amplificateur de puissance 10 amplifie le signal large-bande r(t) de manière linéaire dans un intervalle de linéarité, défini par les composants électroniques de l'amplificateur de puissance 10, et de manière non-linéaire en dehors dudit intervalle de linéarité.

d) Module de calcul d'erreur 12

Le module de calcul d'erreur 12 est configuré pour :

- recevoir un signal large-bande r(t) généré par le module de génération 6,
- recevoir un signal s(t) amplifié par l'amplificateur de puissance 10, et
- déterminer l'erreur, ou différence, entre le signal large-bande r(t) généré par le module de génération 6 reçu et le signal amplifié s(t) reçu.

e) Module de détermination de phase 14

Le module de détermination de phase 14 est configuré pour recevoir l'erreur $\varepsilon(t)$ déterminée par le module de calcul d'erreur 12 et pour calculer une pluralité de déphasages $\varphi_1$, .., $\varphi_8$ pour la pluralité de signaux bande-étroite $e_1(t)$, ..., $e_8(t)$, ces déphasages étant différents entre eux, de manière à réduire le facteur de crête du signal large-bande r(t) et, lorsque les signaux bande-étroite $e_1(t)$, ..., $e_8(t)$ sont au moins en partie cohérents entre eux, à optimiser la distribution statistique des amplitudes du signal large-bande r(t).

Dans les modes de mise en oeuvre décrits ci-après, le module de détermination de phase 14 est configuré pour calculer les déphasages $\varphi_1$, .., $\varphi_8$ des signaux bande-étroite $e_1(t)$, ..., $e_8(t)$ en minimisant, à partir d'un algorithme du gradient stochastique, l'erreur quadratique, cette erreur étant celle calculée par le module de calcul d'erreur 12.

Une telle méthode permet de déterminer des valeurs optimales des déphasages $\varphi_1$, .., $\varphi_8$ pour les signaux bande-étroite $e_1(t)$, ..., $e_8(t)$ de manière à obtenir un facteur de crête minimal pour le signal large-bande r(t) et, lorsque les signaux bande-étroite $e_1(t)$, ..., $e_8(t)$ sont au moins en partie cohérents entre eux, à optimiser la distribution statistique des amplitudes du signal large-bande r(t).

Ceci n'est toutefois pas limitatif de la portée de la présente invention dans la mesure où toute autre méthode connue peut être utilisée pour déphaser des signaux bande-étroite $e_1(t)$, ..., $e_8(t)$ entre eux de manière à réduire le facteur de crête du signal large-bande r(t) et, lorsque les signaux bande-étroite $e_1(t)$, ..., $e_8(t)$ sont au moins en partie cohérents entre eux, à optimiser la distribution statistique des amplitudes du signal large-bande r(t).

Ainsi, par exemple, le déphasage des signaux bande-étroite $e_1(t)$, ..., $e_8(t)$ peut être obtenu par tout moyen adapté, par exemple en modifiant les instants d'échantillonnage des signaux bande-étroite $e_1(t)$, ..., $e_8(t)$ par le module de génération 8 d'un signal large-bande de sorte qu'ils soient temporellement décalés entre eux.

f) Module d'émission 16

Le module d'émission 16 est configuré pour émettre le signal amplifié s(t) par l'amplificateur de puissance 10. A cette fin, le module d'émission 16 comprend de manière connue une antenne d'émission de signal.

Le module de génération 6 d'un signal large-bande r(t), le module de linéarisation 8, l'amplificateur de puissance 10, le module de calcul d'erreur 12, le module de détermination de phase 14 et le module d'émission 16 précédemment mentionnées sont communs aux deux formes de réalisation décrites de l'émetteur 2A/2B selon l'invention.

Dans la deuxième forme de réalisation de l'émetteur 2B selon l'invention illustrée à la figure 2, l'émetteur 2B comprend en outre un simulateur d'amplification de puissance 18 et un différentiateur de signaux 20.

Une telle configuration permet de séparer physiquement le module de génération 8 et l'amplificateur de puissance 10, dans le cas, par exemple, où ils ne sont pas implémentés sur un même circuit électronique ou bien pour le cas où l'on souhaite uniquement réduire le facteur de crête du signal large-bande r(t) (et, lorsque les signaux bande-étroite $e_1(t)$, ..., $e_8(t)$ sont au moins en partie cohérents entre eux, optimiser la distribution statistique des amplitudes du signal large-bande r(t)) sans envoyer systématiquement le signal large-bande r(t) à un amplificateur de puissance réel et effectif tel que l'amplificateur de puissance 10.

A cette fin, l'émetteur 2B est divisé en un premier sous-module émetteur 2B-1, et en un deuxième sous-module émetteur 2B-2, par exemple compris chacun dans une entité physique différente de l'équipement émetteur 2B (sans que cela ne soit limitatif de la portée de la présente invention).

Le premier sous-module émetteur 2B-1 comprend le module de génération d'un signal large-bande 6, le module de détermination de phase 14, le simulateur d'amplification de puissance 18 et le différentiateur de signaux 20.

Le deuxième sous-module émetteur 2B-2 comprend le module de linéarisation 8, l'amplificateur de puissance 10, le module de calcul d'erreur 12 et le module d'émission 16.

g) Simulateur d'amplification de puissance 18

Le simulateur d'amplification de puissance 18 peut être vu comme un amplificateur de puissance virtuel simulant une amplification du signal large-bande de manière similaire à l'amplificateur de puissance 10 afin de déterminer des valeurs de déphasage permettant de réduire le facteur de crête du signal large-bande r(t) et, lorsque les signaux bande-étroite $e_1(t)$, ..., $e_8(t)$ sont au moins en partie cohérents entre eux, d'optimiser la distribution statistique des amplitudes du signal large-bande r(t).

Un tel simulateur 18 permet ainsi avantageusement d'obtenir des valeurs différentes de déphasage $\varphi_1$, .., $\varphi_8$ pour les signaux bande-étroite $e_1(t)$, ..., $e_8(t)$, et donc de réduire le facteur de crête du signal large-bande r(t) (et lorsque les signaux bande-étroite $e_1(t)$, ..., $e_8(t)$ sont au moins en partie cohérents entre eux, d'optimiser la distribution statistique des amplitudes du signal large-bande r(t)) avant de réellement amplifier le signal large-bande r(t) (via l'amplificateur de puissance 10) et d'émettre ledit signal amplifié s(t).

L'amplificateur de puissance 10 réel reçoit donc un signal large-bande r(t) (éventuellement pré-distordu) dont le facteur de crête a déjà été réduit de manière significative et dont les variations d'amplitude sont ainsi déjà comprise dans l'intervalle de linéarité de l'amplificateur de puissance 10 ou dont les occurrences des variations d'amplitude excédant l'intervalle de linéarité de l'amplificateur de puissance 10 sont minimisées.

Le simulateur d'amplification de puissance 18 utilise une fonction mathématique f permettant de simuler l'amplificateur de puissance 10. En d'autres termes, le simulateur d'amplification de puissance 18 détermine un signal de sortie s1 (t) simulé correspondant à un signal amplifié par l'amplificateur de puissance 10 à partir d'un signal large-bande r(t) reçu du module de génération 6.

En référence à la figure 3, la fonction mathématique f est une fonction de compression avec une valeur maximum de sortie appelée « Target » qui est atteinte lorsque la valeur d'entrée augmente au-delà d'une limite maximum d'entrée. Ainsi, lorsque, la valeur d'entrée est inférieure à la limite maximum d'entrée, la valeur de sortie est de l'ordre de la valeur d'entrée.

Deux exemples de fonction f1 et f2 simples sont illustrés à la figure 3 dans laquelle les fonctions f1 et f2 augmente jusqu'à une valeur limite « Target » pour des valeurs supérieures à des valeurs d'entrée respectivement r1 et r2. Les valeurs « Target », r1 et r2, peuvent être exprimées soit en terme d'amplitude (par exemple en μv ou en dB μv), soit en terme de puissance (par exemple en mW ou en dBm).

h) Différentiateur de signaux 20

Le différentiateur de signaux 20 est configuré pour recevoir le signal large-bande r(t) généré par le module de génération 6 et le signal simulé s1(t) par le simulateur d'amplification de puissance 18 et pour déterminer la différence entre ces deux signaux, de manière similaire au module de calcul d'erreur 12.

Dans cette deuxième forme de réalisation illustrée à la figure 2, le module de détermination de phase 14 est configuré pour calculer une pluralité de déphasages $\varphi_1$, .., $\varphi_8$, différents entre eux, pour la pluralité de signaux bande-étroite $e_1(t)$, ..., $e_8(t)$ à partir de l'erreur $\varepsilon_1(t)$ déterminée par le différentiateur de signaux 20 (et non plus par le module de calcul d'erreur 12).

On notera que, dans cette deuxième forme de réalisation, le module de calcul d'erreur 12 calcule, à partir du signal large-bande r(t) généré par le module de génération 6 et du signal s(t) amplifié par l'amplificateur de puissance 10, une erreur $\varepsilon_2(t)$ qu'il fournit au module de linéarisation 8.

La structure de l'émetteur 2 selon l'invention ayant été décrite, le fonctionnement du procédé de réduction de facteur de crête mis en oeuvre par ledit émetteur 2 va maintenant être détaillé.

## II. <u>Mise en oeuvre</u>

Le procédé selon l'invention est décrit ci-après selon deux modes de mise en oeuvre correspondant aux deux formes de réalisation de l'émetteur 2 décrites précédemment en référence aux figures 1 et 2. Ces modes de mise en oeuvre du procédé selon l'invention sont décrits ci-après respectivement en référence aux figures 4 et 5.

a) <u>Premier mode de mise en oeuvre du procédé selon l'invention</u>

Ce premier mode, illustré à la figure 4, est mis en oeuvre par l'équipement émetteur 2A illustré à la figure 1.

Comme expliqué précédemment, l'émetteur 2A comprend un module de génération 6 d'un signal large-bande r(t), un module de linéarisation 8, un amplificateur de puissance 10, un module de calcul d'erreur 12, un module de détermination de phase 14 et un module d'émission 16.

Chaque unité de configuration de phase 60-1, ..., 60-8 du module de génération 6 reçoit :

- dans une étape E1, l'un des huit signaux bande-étroite $e_1(t)$, ..., $e_8(t)$ associé, et
- dans une étape E2, qui peut être concomitante à l'étape E1, une valeur de déphasage $\varphi_1$, .., $\varphi_8$ associée audit signal bande-étroite $e_1(t)$, ..., $e_8(t)$ envoyée par le module de détermination de phase 14.

Lors de la mise en fonctionnement de l'émetteur 2A, des valeurs prédéterminées de déphasage $\varphi_{0-1}$, .., $\varphi_{0-8}$, par exemple choisies de manière aléatoire, peuvent être fournies pour chaque signal $e_1(t)$, ..., $e_8(t)$ au module de génération 6 afin de permettre son initialisation.

En sortie des unités de configuration de phase 60-1, ... 60-8, l'unité de génération 62 génère, dans une étape E3, un signal large-bande r(t) comprenant les huit signaux bande-étroite $e_1(t)$, ..., $e_8(t)$ déphasés par les unités de configuration de phase 60-1, ... 60-8.

Le signal large-bande r(t) généré par le module de génération 6 est envoyé, d'une part, au module de calcul d'erreur 12 et, d'autre part, au module de linéarisation 8.

Le module de linéarisation 8 applique une pré-distorsion au signal qu'il reçoit, dans une étape E4 (optionnelle), puis envoie le signal ainsi pré-distordu à l'amplificateur de puissance 10 qui l'amplifie dans une étape E5. La pré-distorsion appliquée est en général fonction de l'erreur $\varepsilon(t)$ issue du module de calcul d'erreur 12 et reçue préalablement par le module de linéarisation 8, par exemple à l'itération précédente.

Le signal amplifié s(t) est ensuite transmis, d'une part, au module d'émission 16 qui l'émet dans une étape E6 à destination du récepteur 4 et, d'autre part, au module de calcule d'erreur 12 qui calcule, dans une étape E7, l'erreur $\varepsilon(t)$, c'est-à-dire la différence, entre le signal large-bande r(t) généré par le module de génération 6 et le signal amplifié s(t) par l'amplificateur de puissance 10, puis l'envoie au module de détermination de phase 14 et au module de linéarisation 8.

Le module de détermination de phase 14 calcule alors, dans une étape E8, pour chacun des huit signaux bande-étroite $e_1(t)$, ..., $e_8(t)$, une valeur de déphasage $\varphi_1$,.., $\varphi_8$ des signaux bande-étroite $e_1(t)$, ..., $e_8(t)$.

Les valeurs de déphasage $\varphi_1$, .., $\varphi_8$ des signaux bande-étroite $e_1(t)$, ..., $e_8(t)$ peuvent être calculées par minimisation de l'erreur quadratique, de préférence en utilisant un gradient stochastique minimisant ladite erreur quadratique comme décrit ci-après.

Toujours en référence à la figure 1, le signal de sortie du module de génération 6 s'écrit :

$$r(t) = \sum_i w_i . e_i(t)$$

avec i variant de 1 à 8, avec $w_i = e^{j.\varphi_i}$
et l'erreur, ou différence, entre le signal de sortie s(t) de l'amplificateur de puissance 10 et ledit signal d'entrée s'écrit :
$\varepsilon(t) = s(t) - r(t),$

où $s(t) = F(r(t))$ est la fonction réalisée par l'amplificateur de puissance 10.

On en déduit alors :

$$\varepsilon(t) = r(t) - F(r(t)) = G(r(t)) = G\left(\sum_i w_i . e_i(t)\right)$$

où g est la fonction qui a « t » associe « r(t)- s(t) ».

Les déphasages $\varphi_1, .., \varphi_8$ des signaux bande-étroite $e_1(t), ..., e_8(t)$ sont alors déterminées en minimisant l'erreur quadratique.

De manière préférée, les déphasages $\varphi_1, .., \varphi_8$ des signaux sont déterminées en utilisant un gradient stochastique qui minimise l'erreur quadratique $\|\varepsilon\|^2$ :

$$\left\|\varepsilon(t)\right\|^2 = \left\|G\left(\sum_i w_i . e_i(t)\right)\right\|^2$$

Avec : $w_i = e^{j.\varphi_i}$ (j étant un nombre complexe qui est la racine carrée de -1).

On a alors :

$$\frac{\partial\left(\left\|\varepsilon(t)\right\|^2\right)}{\partial \varphi_l} = \mathrm{Re}\left(G\left(\sum e^{j.\varphi_i} . e_i(t)\right) . \frac{\partial G(\sum e^{j.\varphi_i} . e_i(t))^*}{\partial\left(\sum e^{j.\varphi_i} . e_i(t)\right)} . e_l(t)^* . (-j) . e^{-j.\varphi_l}\right)$$

$$= \mathrm{Im}\left(G\left(\sum e^{j.\varphi_i} . e_i(t)\right) . \frac{\partial G(\sum e^{j.\varphi_i} . e_i(t))^*}{\partial\left(\sum e^{j.\varphi_i} . e_i(t)\right)} . e_l(t)^* . e^{-j.\varphi_l}\right)$$

Or, une estimée de $\dfrac{\partial G(\sum e^{j.\varphi_i} . e_i(t))^*}{\partial\left(\sum e^{j.\varphi_i} . e_i(t)\right)}$ (qui est une dérivée complexe) permet d'utiliser la formule comme étant un terme du gradient stochastique. Une estimée possible de $\dfrac{\partial G(\sum e^{j.\varphi_i} . e_i(t))^*}{\partial\left(\sum e^{j.\varphi_i} . e_i(t)\right)}$ est

$$\frac{G(\sum e^{j.\varphi_i} . e_i(t))^*}{\sum e^{j.\varphi_i} . e_i(t)}.$$

De manière préférée, un gradient stochastique est appliqué pour déterminer les valeurs optimales de déphasage des signaux bande-étroite $e_1(t), ..., e_8(t)$ selon la relation :

$$\varphi_{l,k+1} = \varphi_{l,k} - \mu . \mathrm{Im}\left(G\left(\sum e^{j.\varphi_{i,k}} . e_i(t)\right) \frac{\partial G(\sum e^{j.\varphi_{i,k}} . e_i(t))^*}{\partial\left(\sum e^{j.\varphi_{i,k}} . e_i(t)\right)} . e_l(t)^* . e^{-j.\varphi_{l,k}}\right)$$

où $\varphi_{i,n}$ est la phase correspondant au i^ème signal bande-étroite, et n correspond à la n^ème itération de l'algorithme du gradient, i étant supérieur ou égal à 1 et inférieur ou égal à 8 dans l'exemple décrit.

Les valeurs de déphasage $\varphi_1$, .., $\varphi_8$ ainsi déterminées sont alors envoyées aux unités de configuration de phase 60-1, ... 60-8 du module de génération 6 afin qu'elles déphasent les signaux bande-étroite $e_1(t)$, ..., $e_8(t)$ associés dans une étape E9.

b) <u>Deuxième mode de mise en oeuvre du procédé selon l'invention</u>

Ce deuxième mode, illustré à la figure 4, est mis en oeuvre par l'équipement émetteur 2B illustré à la figure 2.

Chaque unité de configuration de phase 60-1, ..., 60-8 du module de génération 6 reçoit :

- dans une étape E1, l'un des huit signaux bande-étroite $e_1(t)$, ..., $e_8(t)$ associé, et
- dans une étape E2, qui peut être concomitante à l'étape E1, une valeur de déphasage $\varphi_1$, .., $\varphi_8$ associée audit signal bande-étroite $e_1(t)$, ..., $e_8(t)$ envoyée par le module de détermination de phase 14.

Lors de la mise en fonctionnement de l'émetteur 2B, des valeurs prédéterminées de déphasage $\varphi_{0-1}$, .., $\varphi_{0-8}$, choisies par exemple de manière aléatoire, peuvent être fournies pour chaque signal $e_1(t)$, ..., $e_8(t)$ au module de génération 6 afin de permettre son initialisation.

En sortie des unités de configuration de phase 60-1, ... 60-8, l'unité de génération 62 génère, dans une étape E3, un signal large-bande r(t) comprenant les huit signaux bande-étroite $e_1(t)$, ..., $e_8(t)$ déphasés par les unités de configuration de phase 60-1, ... 60-8.

Le signal large-bande r(t) généré par le module de génération 6 est reçu, d'une part, par le simulateur d'amplification de puissance 18 du premier sous-module émetteur 2B-1, et, d'autre part, par le module de linéarisation 8 du deuxième sous-module émetteur 2B-2.

Le simulateur d'amplification de puissance 18 simule dans une étape E4' une distorsion (compression) similaire à celle de l'amplificateur de puissance 10 en utilisant une fonction f afin de fournir un signal de sortie f(r(t)) au différentiateur de signaux 20.

Le différentiateur de signaux 20 détermine alors dans une étape E5' la différence $\varepsilon_1(t)$ entre le signal large-bande r(t) généré par le module de génération 6 et le signal f(r(t)) simulé par le simulateur d'amplification de puissance 18 de manière similaire au module de calcul d'erreur 12 puis envoie la valeur d'erreur $\varepsilon_1(t)$ au module de détermination de phase 14.

Le module de détermination de phase 14 calcule alors dans une étape E6', pour chacun des huit signaux bande-étroite $e_1(t)$, ..., $e_8(t)$, une valeur de déphasage $\varphi_1$, .., $\varphi_8$ des signaux bande-étroite $e_1(t)$, ..., $e_8(t)$.

Comme précédemment, les valeurs de déphasage $\varphi_1$, .., $\varphi_8$ des signaux bande-étroite $e_1(t)$, ..., $e_8(t)$ peuvent être calculées par minimisation de l'erreur quadratique, de préférence en utilisant un gradient stochastique minimisant ladite erreur quadratique.

Dans ce cas, on a:

$$\varepsilon_1(t) = r(t) - f(r(t)) = g(r(t)) = g\left(\sum w_i.e_i(t)\right)$$

avec: $w_i = e^{j.\varphi_i}$ et:

$$\frac{\partial\left(\|\varepsilon_1(t)\|^2\right)}{\partial\varphi_l} = \mathrm{Im}\left( g\left(\sum e^{j.\varphi_i}.e_i(t)\right)\frac{\partial g(\sum e^{j.\varphi_i}.e_i(t))^*}{\partial\left(\sum e^{j.\varphi_i}.e_i(t)\right)}.e_l(t)^*.e^{-j.\varphi_l}\right)$$

où g est la fonction qui a « x » associe « x-f(x) ».

g étant connue, $\dfrac{\partial g(x)^*}{\partial x}$ peut être plus aisément déterminée que dans le cas d'un amplificateur de puissance 10 réel décrit dans le premier mode de mise en oeuvre.

La formule du gradient est alors donnée par la relation :

$$\varphi_{l,k+1} = \varphi_{l,k} - \mu.\mathrm{Im}\left( g\left(\sum e^{j.\varphi_{i,k}}.e_i(t)\right) \frac{\partial g\left(\sum e^{j.\varphi_{i,k}}.e_i(t)\right)^*}{\partial\left(\sum e^{j.\varphi_{i,k}}.e_i(t)\right)}.e_l(t)^*.e^{-j.\varphi_{l,k}} \right)$$

où $\varphi_{i,n}$ correspond au i$^{ème}$ signal bande-étroite, et n correspond à la n$^{ème}$ itération de l'algorithme du gradient.

Dans le cas précis où f est une fonction réelle (correspondant à une fonction de compression), on notera que

$$\frac{\partial g(x)^*}{\partial x}$$ est un scalaire réel positif.

Cela veut dire que la modification dans la formule du gradient est effectuée, pour le vecteur composé des $w_i$, dans la direction opposée au vecteur composé des éléments Im($g(\Sigma^{ej.\varphi_i}.e_i(t)).e_l(t)^*.e^{-j.\varphi_l})$, c'est à dire des opposées au vecteur composé des éléments Im($r(t).e_l(t)^*.e^{-j.\varphi_l}$).

Les valeurs de déphasage ainsi déterminées sont alors envoyées aux unités de configuration de phase 60-1, ... 60-8 du module de génération 6 afin qu'elles déphasent les signaux bande-étroite $e_1(t)$, ..., $e_8(t)$ associés dans une étape E7'.

Le module de linéarisation 8 applique, à partir d'une erreur $\varepsilon_2(t)$ calculée par le module de calcul d'erreur 12 (par exemple à l'itération précédente), une pré-distorsion au signal qu'il reçoit, dans une étape E8' (optionnelle), puis envoie le signal ainsi pré-distordu à l'amplificateur de puissance 10 qui l'amplifie dans une étape E9'.

Le signal amplifié est ensuite transmis, d'une part, au module d'émission 16 qui l'émet à destination du récepteur 4 dans une étape E10' et, d'autre part, au module de calcul d'erreur 12 qui calcule, dans une étape E11', une nouvelle erreur $\varepsilon_2(t)$ correspondant à la différence entre le signal large-bande r(t) généré par le module de génération 6 et le signal s(t) amplifié par l'amplificateur de puissance 10, puis la fournit au module de linéarisation 8 de sorte que la linéarisation soit effectuée par itération.

On notera que les étapes E8' à E11' sont optionnelles.

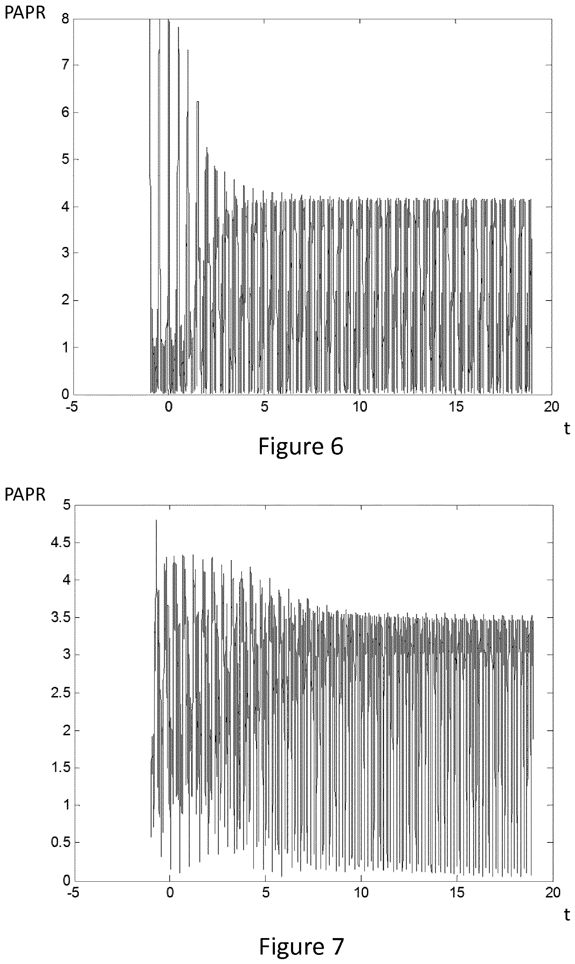

La figure 6 illustre un premier exemple de convergence du facteur de crête pour huit signaux bande-étroite insérés dans un unique signal large-bande pour le deuxième mode de mise en oeuvre utilisant un simulateur d'amplification de puissance 18. Dans ce premier exemple, les signaux bande-étroite sont des porteuses pures.

Dans cet exemple, les signaux bande-étroite sont espacés en fréquence de manière régulière. La puissance de chaque signal bande-étroite est égale à 1. La puissance moyenne pour le signal global comprenant les 8 signaux bande-étroite est égale à 8. La puissance maximale est égale à 64 lorsque les 8 signaux sont en cohérence. Le PAPR est donc égal, sans traitement, à 64/8=8, c'est-à-dire égal à 9 dB environ.

Dans cet exemple, la fonction utilisée est la fonction f2 illustrée à la figure 3 et la valeur de limite de sortie « Target », exprimée en terme d'amplitude est de 4. Elle est donc égale à 16 en termes de puissance. Les phases des signaux bande-étroite sont toutes identiques et égales à zéro au démarrage de la mise en oeuvre. En d'autres termes, leur déphasage est nul.

On constate ainsi que le procédé selon l'invention permet de réduire le facteur de crête (PAPR) d'une valeur d'origine environ égale à 9 dB à une valeur environ égale à 4 dB.

La figure 7 illustre un deuxième exemple de convergence du facteur de crête pour huit signaux bande-étroite inséré dans un unique signal large-bande pour le deuxième mode de mise en oeuvre utilisant un simulateur d'amplification de puissance 18. Dans ce deuxième exemple, les signaux bande-étroite sont aussi des porteuses pures.

Dans cet exemple, les signaux bande-étroite sont espacés en fréquence de manière régulière. La puissance de chaque signal bande-étroite est égale à 1. La puissance moyenne pour le signal global comprenant les 8 signaux bande-étroite est égale à 8. La puissance maximale est égale à 64 lorsque les 8 signaux sont en cohérence. Le PAPR est donc égal, sans traitement, à 64/8=8, c'est-à-dire égal à 9 dB environ.

Dans cet exemple, les signaux bande-étroite sont espacés de manière régulière, la fonction utilisée est la fonction f2 illustrée à la figure 3 et la valeur de limite de sortie « Target », exprimée en terme d'amplitude est de 3,4, ce qui correspond à 11,56 en terme de puissance. Les phases des signaux bande-étroite étant choisies de manière aléatoire au démarrage de la mise en oeuvre.

On constate ainsi que le procédé selon l'invention permet de réduire le facteur de crête (PAPR) d'une valeur d'origine environ égale à 5,6 dB à une valeur environ égale à 1,85 dB.

Lorsque la cohérence entre les signaux bande-étroite, exprimés en bande de base, n'est que partielle ou est limitée seulement à une portion de temps de ces signaux, par exemple dans le cas de TETRAPOL avec les séquences d'apprentissage et lorsque les signaux TETRAPOL sont tous synchronisés entre eux, il est préférable d'utiliser différents pas dans l'algorithme du gradient. Pour TETRAPOL, on choisit par exemple un pas rapide sur la séquence d'apprentissage et un pas plus lent en dehors de celle-ci. Une autre réalisation consiste à n'effectuer l'adaptation des déphasages seulement sur les séquences d'apprentissage. La réduction du PAPR sera plus faible que dans le cas où la cohérence est complète entre les signaux bande-étroite, exprimés en bande de base, mais le traitement apporte une amélioration significative de la distribution statistique de l'amplitude du signal résultant, ce qui contribue à réduire la distorsion subie par le signal large-bande en sortie de l'amplificateur de puissance.

Dans un troisième mode de mise en oeuvre (non illustré), le module de détermination de phase 14 est configuré pour déterminer des valeurs de déphasage de manière aléatoire, ce qui permet de réduire le facteur de crête mais de manière non optimale. Dans ce mode, le procédé comprend une étape périodique de génération d'un signal large-bande à partir de signaux bande-étroite déphasés de manière aléatoire qui est interrompue lorsque le facteur de crête est inférieur à une valeur de facteur de crête de référence.

Bien entendu, d'autres modes de réalisation peuvent être envisagés. Plus particulièrement, la détermination de la phase des signaux bande-étroite peut être réalisée de toute manière adaptée permettant de déphaser les signaux bande-étroite entre eux.

### Revendications

1. Procédé de réduction du facteur de crête d'un signal large-bande (r(t)) généré par un module de génération (6), le signal large-bande (r(t)) comprenant N signaux bande-étroite (e1(t), ..., eN(t)), N étant un nombre entier naturel supérieur ou égale à deux, le procédé, mis en oeuvre par un équipement émetteur (2A, 2B) comprenant un amplificateur de puissance (10) et/ou un simulateur d'amplification de puissance (18), étant **caractérisé en ce qu'**il comprend une étape de déphasage (E9) des signaux bande-étroite (e1(t), ..., eN(t)) entre eux de manière à réduire ledit facteur de crête, les valeurs de déphasages ($\varphi$1, ..., $\varphi$N) des signaux bande-étroite (e1(t), ..., eN(t)) sont déterminées à partir de l'erreur entre la valeur du signal amplifié (s(t), S1 (t)) par ledit amplificateur de puissance (10) ou ledit simulateur d'amplification de puissance (18) et la valeur du signal généré (r(t)) par le module de génération (6).

2. Procédé selon la revendication 1, **caractérisé en ce que** les valeurs de déphasage ($\varphi_1$, ..., $\varphi_N$) des signaux bande-étroite ($e_1(t)$, ..., $e_N(t)$) sont déterminées dans une étape préliminaire.

3. Procédé selon l'une des revendications précédentes, **caractérisé en ce que** les valeurs de déphasage ($\varphi_1$, ..., $\varphi_N$) des signaux bande-étroite ($e_1(t)$, ..., $e_N(t)$) sont déterminées de manière périodique.

4. Procédé selon l'une des revendications précédentes, **caractérisé en ce que** les valeurs de déphasages (($\varphi_1$,.... $\varphi_N$) des signaux bande-étroite ($e_1(t)$, ..., $e_N(t)$) sont déterminées à partir des signaux émis à un instant antérieur par l'équipement émetteur (2A/2B).

5. Procédé selon la revendication 1, **caractérisé en ce que** l'équipement émetteur (2A/2B) comprenant un amplificateur de puissance (10) et/ou un simulateur d'amplification de puissance (18), les valeurs de déphasages ($\varphi_1$, ..., $\varphi_N$) des signaux bande-étroite ($e_1(t)$, ..., $e_N(t)$) sont déterminées en minimisant l'erreur quadratique entre la valeur du signal amplifié (s(t)) par ledit amplificateur de puissance (10) ou ledit simulateur d'amplification de puissance (18) et la valeur du signal généré (r(t)) par le module de génération (6).

6. Procédé selon la revendication 5, **caractérisé en ce que** les valeurs de déphasages ($\varphi_1$, ..., $\varphi_N$) des signaux bande-étroite ($e_1(t)$, ..., $e_N(t)$) sont déterminées en utilisant un gradient stochastique qui minimise ladite erreur quadratique.

7. Procédé selon la revendication 1, **caractérisé en ce que** les valeurs de déphasages ($\varphi_1$, ..., $\varphi_N$) des signaux bande-étroite ($e_1(t)$, ..., $e_N(t)$) sont déterminées de manière aléatoire, de préférence périodiquement.

8. Equipement émetteur (2A, 2B) comprenant un module de génération (6) d'un signal large-bande (r(t)) à partir de N signaux bande-étroite ($e_1(t)$, ..., $e_N(t)$), N étant un nombre entier naturel supérieur ou égale à deux, et un amplificateur de puissance (10) dudit signal large-bande (r(t)), ledit équipement émetteur (2A, 2B) étant **caractérisé en ce que** le module de génération (6) est configuré pour déphaser les signaux bande-étroite ($e_1(t)$, ..., $e_N(t)$) entre eux de manière à réduire le facteur de crête du signal large-bande (r(t)) et, lorsque les signaux bande-étroite ($e_1(t)$, ..., $e_N(t)$) sont au moins en partie cohérents entre eux, à optimiser la distribution statistique des amplitudes du signal large-bande (r(t)).

9. Equipement selon la revendication précédente, **caractérisé en ce qu'**il comprend un simulateur d'amplification de puissance (18) configuré pour simuler l'amplification d'un signal large-bande (r(t)) généré par le module de génération (6).

**Patentansprüche**

1. Reduktionsverfahren des Scheitelfaktors eines Breitbandsignals (r(t)), das durch ein Generationsmodul (6) generiert ist, wobei das Breitbandsignal (r(t)) N Schmalbandsignale ($e_1$(t), ..., $e_N$(t)), umfasst, wobei N eine ganze natürliche Zahl größer als oder gleich zwei ist, wobei das von einer Senderausrüstung (2A, 2B) umgesetzte Verfahren einen Leistungsverstärker (10) und / oder einen Leistungsverstärkersimulator (18) umfasst, der **dadurch gekennzeichnet ist, dass** er eine Phasenverschiebung (E9) der Schmalbandsignale ($e_1$(t), ..., $e_N$(t)) zwischen ihnen derart umfasst, dass der genannte Scheitelfaktor reduziert wird, die Phasenverschiebungswerte ($\varphi$1, ..., $\varphi$N) der Schmalbandsignale ($e_1$(t), ..., $e_N$(t)) ausgehend von dem Fehler zwischen dem Wert des verstärkten Signals (s(t), S1 (t)) durch den genannten Leistungsverstärker (10) oder den genannten Leistungsverstärkersimulator (18) und dem Wert des von dem Generationsmodul (6) generierten Signals (r(t)) bestimmt werden.

2. Verfahren gemäß Anspruch 1, **dadurch gekennzeichnet, dass** die Phasenverschiebungswerte ($\varphi_1$, ..., $\varphi_N$) der Schmalbandsignale ($e_1$ (t), ..., $e_N$ (t)) in einem einleitenden Schritt bestimmt sind.

3. Verfahren gemäß einem der voranstehenden Ansprüche, **dadurch gekennzeichnet, dass** die Phasenverschiebungswerte ($\varphi_1$, ..., $\varphi_N$) der Schmalbandsignale ($e_1$, (t), ..., $e_N$ (t)) periodisch bestimmt sind.

4. Verfahren gemäß irgendeinem der voranstehenden Ansprüche, **dadurch gekennzeichnet, dass** die Phasenverschiebungswerte ($\varphi_1$, ..., $\varphi_N$) der Schmalbandsignale ($e_1$ (t), ..., $e_N$(t)) ausgehend von Signalen bestimmt sind, die zu einem vorherigen Zeitpunkt durch die Senderausrüstung (2A/2B) bestimmt sind.

5. Verfahren gemäß Anspruch 1, **dadurch gekennzeichnet, dass**, da die Senderausrüstung (2A/2B) einen Leistungsverstärker (10) und / oder einen Leistungsverstärkersimulator (18) umfasst, die Phasenverschiebungswerte ($\varphi_1$, ..., $\varphi_N$) der Schmalbandsignale ($e_1$ (t), ..., $e_N$ (t)) per Minimierung des quadratischen Fehlers zwischen dem Wert durch den genannten Leistungsverstärker (10) oder den genannten Leistungsverstärkersimulator (18) des verstärkten Signals (s(t)) und dem Wert des durch das Generationsmodul (6) generierten Signals (r(t)) bestimmt sind.

6. Verfahren gemäß Anspruch 5, **dadurch gekennzeichnet, dass** die Phasenverschiebungswerte ($\varphi_1$, ..., $\varphi_N$) der Schmalbandsignale ($e_1$ (t), ..., $e_N$ (t)) unter Verwendung eines stochastischen Gradienten, der den genannten quadratischen Fehler minimiert, bestimmt sind.

7. Verfahren gemäß Anspruch 1, **dadurch gekennzeichnet, dass** die Phasenverschiebungswerte ($\varphi_1$, ..., $\varphi_N$) der Schmalbandsignale ($e_1$ (t), ..., $e_N$ (t)) zufällig, bevorzugt periodisch, bestimmt sind.

8. Senderausrüstung (2A, 2B), umfassend ein Generationsmodul (6) eines Breitbandsignals (r(t)) ausgehend von N Schmalbandsignalen ($e_1$ (t), ..., $e_N$ (t)), wobei N eine natürliche ganze Zahl größer als oder gleich zwei ist, und einen Leistungsverstärker (10) des genannten Breitbandsignals (r(t)), wobei die genannte Senderausrüstung (2A, 2B) **dadurch gekennzeichnet ist, dass** das Generationsmodul (6) konfiguriert ist, um die Schmalbandsignale ($e_1$ (t), ..., $e_N$ (t)) untereinander derart in den Phasen zu verschieben, dass der Scheitelfaktor des Breitbandsignals (r(t)) reduziert wird und, wenn die Schmalbandsignale ($e_1$ (t), ..., $e_N$ (t)) wenigstens zum Teil untereinander kohärent sind, die statistische Verteilung der Amplituden des Breitbandsignals (r(t)) zu optimieren.

9. Ausrüstung gemäß dem voranstehenden Anspruch, **dadurch gekennzeichnet, dass** sie einen Leistungsverstärkersimulator (18) umfasst, der konfiguriert ist, um die Verstärkung eines von dem Generationsmodul (6) generierten Breitbandsignals (r(t)) zu simulieren.

**Claims**

1. Method for reducing the peak factor of a broadband signal (r(t)) generated by a generation module (6), with the broadband signal (r(t)) comprising N narrow-band signals (e1(t), ..., eN(t)), N being a natural integer greater than or equal to two, the method, implemented by a piece of emitting equipment (2A, 2B) comprising a power amplifier (10) and/or a power amplification simulator (18), **characterised in that** it comprises a phase shifting step (E9) of the narrow-band signals (e1 (t), ..., eN(t)) between them in such a way as to reduce said peak factor, the phase shifting values ($\varphi$1 , ..., $\varphi$N) of the narrow-band signals (e1(t), ..., $e_N$(t)) are determined using the error between the value of the signal amplified (s(t), S1 (t)) by said power amplifier (10) or said power amplification simulator (18) and the value of the signal generated (r(t)) by the generation module (6).

**2.** Method according to claim 1, **characterised in that** the phase shifting values ($\varphi$1, ..., $\varphi$N) of the narrow-band signals (e1(t), ..., eN(t)) are determined in a preliminary step.

**3.** Method according to one of the preceding claims, **characterised in that** the phase shifting values ($\varphi$1, ..., $\varphi$N) of the narrow-band signals (e1(t), ..., eN(t)) are determined periodically.

**4.** Method according to one of the preceding claims, **characterised in that** the phase shifting values ($\varphi$1, ..., $\varphi$N) of the narrow-band signals (e1(t), ..., eN(t)) are determined using signals emitted at a prior instant by the emitting equipment (2A/2B).

**5.** Method according to claim 1, **characterised in that** the emitting equipment (2A/2B) comprising a power amplifier (10) and/or a power amplification simulator (18), the phase shifting values ($\varphi$1, ..., $\varphi$N) of the narrow-band signals (e1(t), ..., $e_N$(t)) are determined by minimising the square error between the value of the signal amplified (s(t)) by said power amplifier (10) or said power amplification simulator (18) and the value of the signal generated (r(t)) by the generation module (6).

**6.** Method according to claim 5, **characterised in that** the phase shifting values ($\varphi$1, ..., $\varphi$N) of the narrow-band signals (e1(t), ..., eN(t)) are determined by using a stochastic gradient that minimises said square error.

**7.** Method according to claim 1, **characterised in that** the phase shifting values ($\varphi$1, ..., $\varphi$N) of the narrow-band signals (e1(t), ..., eN(t)) are determined randomly, more preferably periodically.

**8.** Piece of emitting equipment (2A, 2B) comprising a module for generating (6) a broadband signal (r(t)) using N narrow-band signals (e1(t), ..., eN(t)), N being a natural integer greater than or equal to two, and a power amplifier (10) of said broadband signal (r(t)), said piece of emitting equipment (2A, 2B) **characterised in that** the generation module (6) is configured to shift the phase of the narrow-band signals (e1(t), ..., eN(t)) between them in such a way as to reduce the peak factor of the broadband signal (r(t)) and, when the narrow-band signals (e1(t), ..., eN(t)) are at least partially coherent with each other, to optimise the statistical distribution of the amplitudes of the broadband signal (r(t)).

**9.** Equipment as claimed in the preceding claim, **characterised in that** it comprises a power amplification simulator (18) configured to simulate the amplification of a broadband signal (r(t)) generated by the generation module (6).

Figure 1

Figure 2

Figure 3

Figure 4

Figure 5

Figure 6

Figure 7